# EUROPÄISCHE PATENTSCHRIFT

(11) **EP 3 304 583 B1**
(45) Veröffentlichungstag und Bekanntmachung des Hinweises auf die Patenterteilung: **27.05.2020**
(21) Anmeldenummer: 16728875.2
(22) Anmeldetag: 01.06.2016
(51) Int. Cl.: H01L 21/67, H01L 21/68

(54) **VERFAHREN ZUM AUSRICHTEN VON SUBSTRATEN VOR DEM BONDEN**
METHOD FOR ALIGNING SUBSTRATES BEFORE BONDING
PROCÉDÉ D'ORIENTATION DE SUBSTRATS AVANT LA LIAISON

(30) Priorität: 05.06.2015 DE 102015108901
(43) Veröffentlichungstag der Anmeldung: 11.04.2018
(73) Patentinhaber: EV Group E. Thallner GmbH, 4782 St. Florian am Inn (AT)
(72) Erfinder: DRAGOI, Viorel, 4782 St. Florian am Inn (AT)
(74) Vertreter: Schneider, Sascha
(86) Internationale Anmeldenummer: PCT/EP2016/062360
(87) Internationale Veröffentlichungsnummer: WO 2016/193296

(56) Entgegenhaltungen:
- EP-A1- 1 278 245
- JP-A- 2009 147 257
- US-A1- 2008 187 413
- US-A1- 2013 147 942

## Beschreibung

Die vorliegende Erfindung betrifft ein Verfahren zum Ausrichten eines mindestens zwei erste Ausrichtungsmarkierungen aufweisenden ersten Substrats mit einem mindestens zwei zweite Ausrichtungsmarkierungen aufweisenden zweiten Substrat gemäß Anspruch 1 sowie eine korrespondierende Vorrichtung gemäß Anspruch 7.

Es existieren mehrere Verfahren, um zwei, insbesondere strukturierte, Substrate zueinander auszurichten und zu verbinden (Bonden). In der Mehrzahl aller Verfahren sind die Ausrichtungsanlage (engl.: aligner) und der Bonder getrennte Module/Kammern. Die Ausrichtungsanlage orientiert zwei Substrate mit Hilfe von Ausrichtungsmarkierungen (engl.: alignment marks) zueinander. Nach der Ausrichtung erfolgt eine Fixierung, insbesondere durch Klemmung. Die beiden Substrate werden dazu aneinander und an einem Probenhalter fixiert. Denkbar ist auch die Fixierung der Substrate zueinander ohne Verwendung eines Probenhalters. Eine derartige Fixierung ohne Probenhalter ist in der Druckschrift WO2014154272A1 offenbart, in der aufgezeigt wird, wie mittels magnetischer Körper eine Direktfixierung zweier Substrate erfolgen kann.

Die zueinander fixierten Substrate gelangen dann mittels eines Transportsystems in eine Bondinganlage, in welcher die Kontaktierung der beiden Substrate erfolgt. Einen Spezialfall einer solchen Bondinganlage stellt ein Fusionsbonder dar. Unter einem Fusionsbonder versteht man eine Vorrichtung, die eine Verbondung zweier Substrate durch eine, insbesondere zentrische, Kontaktierung mit Hilfe eines Pins, erzeugt. Durch die extrem reinen Oberflächen der Substrate kommt es zu der Selbstfixierung durch die Adhäsionskräfte zwischen den Substratoberflächen. Bei den Adhäsionskräften handelt es sich vorwiegend um van-der-Waals Kräfte. Ein so erzeugter Bond wird als Vorbond (engl.: prebond) bezeichnet, da er noch nicht über die volle theoretisch zu erreichende Festigkeit verfügt, die in einem weiteren Prozessschritt durch eine Wärmebehandlung und die damit einhergehende Erzeugung kovalenter Verbindungen hergestellt wird.

Bei der Ausführung eines Fusionsbonds bestehen im Wesentlichen zwei große Probleme.

Das erste Problem besteht darin, die Ausrichtungsgenauigkeit über weite Strecken aufrecht zu erhalten. Moderne Ausrichtungsanlagen sind bereits in der Lage, Ausrichtungsgenauigkeiten unter 200 nm zu erzielen. Das bedeutet, dass zwei Substrate mit entsprechenden Ausrichtungsmarkierungen genauer als 100-200 nm zueinander ausgerichtet und zueinander fixiert werden können. Diese Ausrichtungsgenauigkeit muss allerdings über möglichst lange Zeiten und/oder möglichst lange Strecken aufrechterhalten werden. Des Weiteren muss die Fixierung der beiden Substrate zueinander so stark erfolgen, dass die erreichte Ausrichtungsgenauigkeit nicht durch eine Verschiebung der Substrate zueinander, insbesondere während eines Handhabungsprozesses, beispielsweise durch einen Roboter, verloren geht.

Das zweite Problem besteht darin, dass der Durchsatz bei der Ausrichtung und damit bei der Herstellung eines Bonds bei den bisher bekannten Verfahren meist gering ist. In sehr vielen Fällen wird eine aufwendige und damit kostspielige Ausrichtungsanlage verwendet, die in der Lage ist, unterschiedliche Ausrichtungsmethoden, insbesondere face-to-face, back-to-face oder back-to-back Ausrichtungen durchzuführen.

Eine erfindungsgemäß bevorzugt verwendete Bonderart sind Thermokompressionsbonder. Mit Hilfe eines Thermokompressionsbonders können hohe Drücke und hohe Temperaturen erzeugt werden. Er wird vorzugsweise zum Metalldiffusionsbonden und/oder zum eutketischen Bonden verwendet. Da die Metalloberflächen vorzugsweise vollkommen frei von Oxiden sein sollten, ist es von fundamentaler Bedeutung, die Atmosphäre in solchen Bonderkammern gezielt einstellen und überwachen zu können. Die vorliegende Erfindung zeigt nicht nur eine einfache Methode auf, den Durchsatz des Bondens zu erhöhen, sondern beschreibt in vorteilhafter Weise eine Ausführungsform und ein Verfahren, mit welchen eine kontrollierte Atmosphäre in einer Bondkammer erzeugt und kontinuierlich aufrecht erhalten werden kann. Derartige Atmosphären sind besonders vorteilhaft für die Herstellung reiner Metall-Metallbonds.

Es ist Aufgabe der Erfindung, ein Verfahren und eine Anlage aufzuzeigen, mit deren Hilfe eine verbesserte und vor allem schnellere Ausrichtung zweier Substrate zueinander durchgeführt werden kann. Diese Aufgabe wird mit den Merkmalen der Ansprüche 1 und 7 gelöst. Vorteilhafte Weiterbildungen der Erfindung sind in den Unteransprüchen angegeben.

Der Erfindung liegt der Gedanke zugrunde, ein Verfahren zum Ausrichten eines mindestens zwei erste Ausrichtungsmarkierungen aufweisenden ersten Substrats mit einem mindestens zwei zweite Ausrichtungsmarkierungen aufweisenden zweiten Substrat vorzusehen, wobei
- durch eine erste Zuordnung die ersten Ausrichtungsmarkierungen mindestens zwei ersten charakteristischen Ausrichtungsmerkmalen des ersten Substrats in einer X-Richtung und in einer Y-Richtung zugeordnet werden,
- durch eine zweite Zuordnung die zweiten Ausrichtungsmarkierungen mindestens zwei zweiten charakteristischen Ausrichtungsmerkmalen des zweiten Substrats in einer X-Richtung und in einer Y-Richtung zugeordnet werden und
- durch eine Ausrichtung die ersten und zweiten Ausrichtungsmarkierungen mittels der ersten und zweiten charakteristischen Ausrichtungsmerkmale zueinander in X- und Y-Richtung ausgerichtet werden.

Vorrichtungsgemäß lässt sich die Erfindung insbesondere durch folgende Merkmale umsetzen:
- einem ersten Zuordnungsmodul zur Zuordnung der ersten Ausrichtungsmarkierungen zu mindestens zwei ersten charakteristischen Ausrichtungsmerkmalen des ersten Substrats in einer X-Richtung und in einer Y-Richtung,
- einem zweiten Zuordnungsmodul zur Zuordnung der zweiten Ausrichtungsmarkierungen zu mindestens zwei zweiten charakteristischen Ausrichtungsmerkmalen des zweiten Substrats in einer X-Richtung und in einer Y-Richtung und
- einem, insbesondere als Bondmodul ausgebildeten, Ausrichtungsmodul zur Ausrichtung der ersten und zweiten Ausrichtungsmarkierungen mittels der ersten und zweiten charakteristischen Ausrichtungsmerkmale zueinander in X- und Y-Richtung.

Ein Kern der Erfindung besteht insbesondere darin, dass die ersten und zweiten Ausrichtungsmarkierungen der Substrate vor der Weitergabe in die Bondinganlage beziehungsweise ein Bondingmodul, insbesondere einen Fusionsbonder, noch bevorzugter einen Thermokompressionsbonder, in Bezug zu charakteristischen Substratmerkmalen, insbesondere einer abgeflachten Seite (engl.: flat) und/oder einer Kerbe (engl.: notch), vermessen/erfasst werden. Denkbar wäre auch eine Vermessung/Erfassung in Bezug zu anderen charakteristischen Substratmerkmalen, die für die Optiken erkennbar und erfassbar sind. Diese Vermessung/Erfassung erfolgt dabei mit bestmöglicher Präzision. Die Vermessung ist insbesondere genauer als 100 µm, vorzugsweise genauer als 10 µm, noch bevorzugter genauer als 1 µm, am bevorzugtesten genauer als 100 nm, am allerbevorzugtesten genauer als 50 nm. Denkbar ist auch, dass eine Aussage über die Genauigkeit der Substratrotation (Rotationswinkellage) zueinander gemacht wird. Die Substrate sind insbesondere genauer als 1°, bevorzugter genauer als 0.1°, noch bevorzugter genauer als 0.01°, am bevorzugtesten genauer als 0.001°, am allerbevorzugtesten genauer als 0.0001° bezüglich deren Rotationsorientierung zueinander orientiert.

Auf Basis der Vermessung/Erfassung wird vorzugsweise eine exakte Positionskarte der Ausrichtungsmarkierungen in Bezug zu den charakteristischen Substratmerkmalen erstellt (Zuordnung). Durch diese Vorvermessung braucht in der Bondinganlage nur eine Ausrichtung in Bezug zu den charakteristischen Substratmerkmalen und insbesondere nicht zu den ersten und/oder zweiten Ausrichtungsmarkierungen erfolgen.

Das ist insbesondere dann von Vorteil, wenn sich die Ausrichtungsmarkierungen an den miteinander zu verbondenden Substratoberflächen befinden und so durch ein sehr genaues aber langwieriges Ausrichtungsverfahren ausgerichtet werden müssten. Ausrichtungsanlagen, die eine derartiges face-to-face Ausrichtung vornehmen, sind beispielsweise in den Druckschriften JP2009147257A, PCT/EP2013/075831, WO2014202106A1 oder US6214692B1 offenbart. Neben den genannten Druckschriften existieren noch andere Ausrichtungsanlagen, welche eine face-to-face Ausrichtung durch das Einfügen von Optiken zwischen die Substrate bewerkstelligen. Erfindungsgemäß kann somit die Einführung eines optischen Messgeräts zwischen die Substrate oder eine Relativverschiebung beider Substrate zueinander zur Vermessung unterbleiben.

Der Erfindung liegt insbesondere weiter der Gedanke zugrunde, eine Zuordnung der, insbesondere vom Seitenumfang beabstandeten, Ausrichtungsmarkierungen zu, insbesondere am Seitenumfang angeordneten, charakteristischen Substratmerkmalen in einer, insbesondere der jeweiligen Substratoberfläche entsprechenden, X-Y-Ebene, insbesondere vor dem Transfer in eine Bondkammer, durchzuführen. Die Zuordnung erfolgt insbesondere durch Definition eines entsprechenden Vektors in einem definierten Vektorraum, vorzugsweise zumindest bezogen auf die X-Y-Ebene.

Die Erfindung betrifft somit insbesondere eine Vorrichtung und ein Verfahren zur Erhöhung des Durchsatzes einer Bondinganlage. Die Bondinganlage besteht vorzugsweise aus mindestens einer Bondkammer und mindestens zwei, insbesondere als Schleusen ausgebildeten, Zuordnungsmodulen, in denen jeweils eine Vermessung von ersten und zweiten Substraten erfolgt. Ein Transfermittel, vorzugsweise ein Roboter, befördert die ersten und zweiten Substrate jeweils von den Schleusen in die Bondkammer einer Bondanlage oder eines Bondmoduls. In der Bondkammer erfolgt die Ausrichtung der beiden Substrate anhand der charakteristischen Merkmale und/oder die Kontaktierung beider Substrate. Als weiteres besonders bevorzugtes, erfindungsgemäßes Merkmal wird die Möglichkeit offenbart, dass der Roboter, der den Transport der Substrate aus den Zuordnungsmodulen in die Bondkammer durchführt, die Substrate bereits so in der Bondkammer ablegt, dass eine weitere Ausrichtung in der Bondkammer nicht notwendig ist. Die Ablage impliziert somit bei dieser Ausführungsform die Ausrichtung. Die beiden Substrate werden dann in der Bondanlage nach Ablage miteinander verbondet. Bei der Bondanlage / dem Bondmodul handelt es sich insbesondere um einen Fusionsbonder, noch bevorzugter um einen Thermokompressionsbonder.

Mit anderen Worten beruht die vorliegende Erfindung insbesondere darauf, vor einem Transfer der ersten und zweiten Substrate durch Vermessung/Erfassung jeweils korrespondierende erste und zweite Ausrichtungsmarkierungen korrespondierenden charakteristischen Substratmerkmalen zuzuordnen. Die Zuordnung erfolgt insbesondere jeweils in einer durch eine X-Richtung und eine Y-Richtung definierten X-Y-Ebene parallel zu den ersten und zweiten Substratoberflächen.

Ein großer Vorteil einer erfindungsgemäßen Ausführungsform nach einem oder mehreren der vorbeschriebenen Merkmale besteht vor allem darin, dass eine relativ genaue Vermessung der ersten und zweiten Ausrichtungsmarkierungen ausgelagert aus dem Bondingmodul, insbesondere in einer Schleuse, erfolgen kann. Durch die Vermessung der Substratoberflächen und die genaue Kartierung der Ausrichtungsmarkierungen in Bezug zu charakteristischen Substratmerkmalen kann insbesondere die Zeit, in der die Schleuse evakuiert wird, ausgenutzt werden. Somit wird insbesondere das Problem der Ausrichtung zweier an, insbesondere vom Seitenumfang beabstandeten, Kontaktflächen der Substrate beziehungsweise Substratoberflächen liegenden, Ausrichtungsmarkierungen zueinander gelöst, indem die Ausrichtung an Hand charakteristischer Substratmerkmale erfolgt. Diese sind insbesondere in kontaktiertem Zustand der Substrate an den Kontaktflächen noch von außen zugänglich, so dass bis zur Kontaktierung, vorzugsweise kontinuierlich, eine Ausrichtung erfolgen kann. Durch diese Maßnahme kann auf face-to-face-Ausrichtungsstrategien oder eine Verschiebung der Substrate parallel zu den Substratoberflächen über das Ausrichten hinaus verzichtet werden. Die Ausrichtungsmarkierungen sind von den charakteristischen Substratmerkmalen beabstandet, wobei die charakteristischen Substratmerkmale vorzugsweise am Seitenumfang beziehungsweise an einer durch die X-Y-Ebene definierten Außenkontur der Substrate angeordnet sind und die Ausrichtungsmarkierungen vom Seitenumfang beabstandet sind.

Erfindungsgemäß ist es vorgesehen, dass nach der ersten und zweiten Zuordnung und vor der Ausrichtung ein Transfer der Substrate in ein Bondmodul beziehungsweise in eine Bondkammer erfolgt, in welchem/welcher insbesondere die Ausrichtung, vorzugsweise unter einem Gasdruck kleiner 1 bar, noch bevorzugter weniger als 10⁻³ mbar, noch bevorzugter weniger als 10⁻⁵ mbar, am bevorzugtesten weniger als 10⁻⁸ mbar, durchgeführt wird.
Ein wesentlicher erfindungsgemäßer Aspekt besteht gemäß einer Ausführungsform darin, dass die, Bondkammer vorzugsweise durchgehend, evakuiert bleibt und während des Betriebs der Anlage nicht zur Atmosphäre hin geöffnet wird, während die Zuordnungen in den Zusatzmodulen erfolgen. Sollte nach einer Evakuierung die Bondkammer mit einem, insbesondere nicht oxidierenden, Gas bzw. Gasgemisch geflutet werden, so bleibt diese Gasatmosphäre vorzugsweise erhalten.

In Weiterbildung der Erfindung ist es vorgesehen, dass die erste Zuordnung in einem ersten, insbesondere als Schleuse ausgebildeten, ersten Zuordnungsmodul und die zweite Zuordnung, insbesondere parallel zur ersten Zuordnung, in einem zweiten, insbesondere als Schleuse ausgebildeten, zweiten Zuordnungsmodul erfolgen. Hierdurch wird die Zuordnung nicht nur beschleunigt, sondern es ist denkbar, dass die Zuordnungen an den Außenseiten und/oder an vorhandenen oder nachträglich erzeugten Konturen der Substrate erfolgen können. Somit kann auf ein Drehen der Substrate vor dem Kontaktieren der Substrate zum Bonden verzichtet werden.

Mit Vorteil wird vor der Ausrichtung, insbesondere im ersten und/oder zweiten Zuordnungsmodul, vorzugsweise während der Zuordnung, der Gasdruck reduziert wird, vorzugsweise auf einen Gasdruck von weniger als 1 bar, noch bevorzugter weniger als 10⁻³ mbar, noch bevorzugter weniger als 10⁻⁵ mbar, am bevorzugtesten weniger als 10⁻⁸ mbar. Somit kann - insbesondere bei Ausbildung der Zuordnungsmodule als Schleusen - das Bonden in der Bondkammer beschleunigt werden, da diese nicht mehr oder nicht mehr so weit evakuiert zu werden braucht. Die Evakuierung eines Zuordnungsmodul dauert insbesondere weniger als 5 Minuten, vorzugsweise weniger als 4 Minuten, noch bevorzugter weniger als 3 Minuten, am bevorzugtesten weniger als 2 Minuten, am allerbevorzugtesten weniger als 1 Minute. Je schneller die Evakuierung erfolgt, desto größer ist der Durchsatz.

In einer weiteren erfindungsgemäßen Ausführungsform kann die erfindungsgemäße Vermessung der Substrate auch in einem Zuordnungsmodul erfolgen, das von der Bondkammer getrennt vorliegt. Die Substrate werden dann über eine längere Strecke, in eine Bondkammer transportiert. Insbesondere können die Substrate zwischen der erfindungsgemäßen Vermessung und dem eigentlichen Bondvorgang in der Bondkammer durch andere Prozessschritte weiter prozessiert werden. Damit ist die Vermessung der Substrate in den Zuordnungsmodulen selbst ein erfindungsgemäßer Schritt.

In einer weiteren erfindungsgemäßen Ausführungsform können die Vermessungen in den Zuordnungsmodulen auch erfolgen, wenn die Zuordnungsmodule zur umgebenden Atmosphäre hin offen sind. Damit können die Zuordnungsmodule auch ausschließlich zur Vermessung der charakteristischen Substratmerkmale verwendet werden, ohne den Effekt der Vermessung während einer Evakuierung ausnutzen zu müssen. Als weiterer erfindungsgemäßer Aspekt wird daher ausschließlich das Zuordnungsmodul zur Vermessung der charakteristischen Substratmerkmale unabhängig von einer Evakuiierung und/oder eine Anbindung an einen Bonder offenbart.

### Module

Soweit Module wie insbesondere Zuordnungsmodule, Ausrichtungsmodule oder Vermessungsmodule beschrieben werden, sind diese insbesondere als räumlich getrennte Kammern ausgebildet, die vorzugsweise über Schleusen miteinander verbunden werden können. Somit sind die Kammern evakuierbar ausgebildet, insbesondere jeweils auf einen Gasdruck kleiner als 1 bar, vorzugsweise weniger als 10⁻³ mbar, noch bevorzugter weniger als 10⁻⁵ mbar, am bevorzugtesten weniger als 10⁻⁸ mbar. Vorzugsweise sind die Gasdrücke in den Kammern jeweils separat und unabhängig voneinander einstellbar. Module dienen auch der Vor- und/oder Nachbehandlung der Substrate bzw. des gebondeten Substratstapels. So ist es denkbar, dass die Substrate vor dem Einbringen in die erfindungsgemäßen Zuordnungsmodule inspiziert, vermessen, gedreht (engl.: flipped), gereinigt, geätzt und/oder beschichtet werden.

### Steuerungseinrichtung

Die Steuerung der Vorrichtung und beschriebenen Verfahrensmerkmale erfolgt bevorzugt durch eine, insbesondere zentrale, Steuerungseinrichtung. Diese ist vorzugsweise softwaregesteuert beziehungsweise weist eine Firm- und/oder Hard- und/oder Software auf, die insbesondere Speicher zur Speicherung von Daten/Informationen in Bezug auf die Vorrichtung und die Ausrichtung/Zuordnung aufweist.

### Die Substrate

Die Substrate können eine beliebige, vorzugsweise zumindest überwiegend kreisrunde und/oder flache, Form besitzen. Bei den Substraten handelt es sich insbesondere um, vorzugsweise genormte, Halbleitersubstrate, insbesondere Wafer. Die Substrate werden insbesondere durch ihren Durchmesser im kreisrunden Abschnitt beschrieben. Für Wafer werden bevorzugt industrieübliche Durchmesser, nämlich 1 Zoll, 2 Zoll, 3 Zoll, 4 Zoll, 5 Zoll, 6 Zoll, 8 Zoll, 12 Zoll und 18 Zoll, verwendet. Die erfindungsgemäße Ausführungsform kann aber grundsätzlich jedes Substrat, unabhängig von dessen Durchmesser handhaben.

Folgende zwei Waferarten werden bevorzugt verwendet:
Die erste Waferart besitzt eine durch einen geraden Umfangsabschnitt/Substratrandabschnitt (engl.: flat) erzeugte starke Abweichung von der im Übrigen kreisrunden Form des Wafers. Das charakteristische Substratmerkmal ist mindestens einer der beiden Schnittpunkte einer, insbesondere als Sekante des geraden Umfangsabschnitt/Substratrandabschnitts verlaufenden, Geraden. Die zweite Waferart ist bis auf eine Kerbe (engl.: notch) kreisrund. Die Kerbe dient vorzugsweise der Ausrichtung und/oder Grobjustierung, also als charakteristisches Substratmerkmal.

### Charakteristische Substratmerkmale

Unter einem charakteristischen Substratmerkmal wird erfindungsgemäß insbesondere eine dem Substrat, insbesondere einer geometrischen Position an der Substrataußenkontur, eindeutig zuordenbare Stelle/Position verstanden. Das charakteristische Substratmerkmal, insbesondere dessen Position in X-Richtung, Y-Richtung und vorzugsweise zusätzlich in Z-Richtung, ist vorzugsweise optisch erfassbar. Die Position ist auf Grund der Dimension des charakteristischen Substratmerkmals mit einer Genauigkeit von weniger als 100 µm, vorzugsweise weniger als 10 µm, noch bevorzugter weniger als 1 µm, am bevorzugtesten weniger als 100 nm, am allerbevorzugtesten weniger als 10 nm erfassbar.

Bei dem charakteristischen Substratmerkmal kann es sich insbesondere um einen Schnittpunkt des geraden Umfangsabschnitts mit dem kreisförmigen Umfangsabschnitt des Substrats handeln. Weitere charakteristische Merkmale können durch die Kerbe oder markante, mikro- oder nanometergroße Konturen entlang des Substratrandes sein. Insbesondere sind charakteristische Merkmale für jedes einzelne Substrat unterschiedlich. Als charakteristische Merkmale kommen erfindungsgemäß insbesondere folgende in Frage:
- Ausrichtungsmarken an der Außenseite der Substrate und/oder
- kreisförmiger Substratrandabschnitt und/oder
- gerader Substratrandabschnitt und/oder
- kerbartig geformter Substratrandabschnitt und/oder
- Schnittpunkte der vorgenannten Merkmale und/oder
- Schnittpunkte von Tangenten der vorgenannten Merkmale.

Die charakteristischen Substratmerkmale sind insbesondere eindeutig erkennbar/zuordenbar, stabil und/oder wiederauffindbar. Die charakteristischen Substratmerkmale weisen einen eindeutigen Bezugspunkt auf, der bevorzugt mit Messgeräten, insbesondere Mikroskopen, wiedergefunden werden kann.

Die charakteristischen Substratmerkmale sind insbesondere am Rand oder der Außenkontur der Substrate oder zumindest im randnahen Bereich, also der Peripherie, angeordnet, sodass die Messgeräte sie während der Annäherung und bis zur Kontaktierung der Substrate in der Bondinganlage erfassen können. Des Weiteren erlauben weiter außen liegende charakteristische Substratmerkmale eine erhöhte Ausrichtungsgenauigkeit.

Durch die charakteristischen Substratmerkmale kann vorzugsweise ein eindeutiger Fixpunkt in Bezug auf die auf der Substratoberfläche, insbesondere an der Innenseite der Substrate, vorhandenen Ausrichtungsmarkierungen definiert, insbesondere berechnet, werden. Innen oder Innenseite sind die Oberflächen, die später verbondet werden (Kontaktflächen). Außen oder Außenseite sind die den Innenseiten gegenüberliegenden Oberflächen.

Die charakteristischen Substratmerkmale können sich auf derselben Substratoberfläche wie die Ausrichtungsmarkierungen oder (bevorzugt) auf der den Ausrichtungsmarkierungen gegenüberliegenden Substratoberfläche oder (noch bevorzugter) am Seitenrand befinden. Sollten sich die charakteristischen Substratmerkmale auf derselben Substratoberfläche wie die Ausrichtungsmarkierungen befinden und sollten sich die Ausrichtungsmarkierungen an der Innenseite, daher an den Oberflächen, die erfindungsgemäß verbondet werden, befinden, so werden die charakteristischen Merkmale vorzugsweise so weit wie möglich an der Peripherie der Substrate angeordnet, damit optische Geräte, vorzugsweise während des gesamten Annäherungsprozesses, in der Bondkammer detektieren können.

Die charakteristischen Substratmerkmale sind vorzugsweise Teile des Substrats und wurden nicht vor dem erfindungsgemäßen Prozess in das Substrat als solche eingebracht. Denkbar wäre allerdings auch eine Herstellung charakteristischer Substratmerkmale, insbesondere durch die Erzeugung von Mustern an der Außenoberfläche der Substrate, an der Substrataußenkontur oder dem Seitenrand, insbesondere durch einen Laser, einen Ätzprozess oder ein lithographisches Herstellverfahren. Dadurch wird die Ausrichtung unabhängig von, insbesondere durch dritte Personen vorgegebene, Ausrichtungsmarkierungen. Denkbar ist auch die Herstellung sehr feiner Ätzgrübchen an der äußeren Peripherie des Substrats.

### Die Anlage

In einer ersten erfindungsgemäßen Ausführungsform besteht die Anlage aus einer Bondkammer und mindestens einem Zuordnungsmodul, insbesondere einer Schleuse, vorzugsweise aus zwei, insbesondere parallel geschalteten und/oder nebeneinander angeordneten, Schleusen. In besonderen Ausführungsformen können mehr als zwei Schleusen vorhanden sein, um den Durchsatz weiter zu erhöhen. Die Anzahl der Schleusen ist insbesondere größer als 2, vorzugsweise größer als 3, noch bevorzugter größer als 5. Im weiteren Verlauf wird exemplarisch eine Anlage mit genau zwei Schleusen (bevorzugte Ausführungsform) beschrieben.

Die Schleusen besitzen erste Schleusentore, welche die Schleusen von der Umgebung trennen und zweite Schleusentore, welche die Schleusen von der Bondkammer trennen. Die Schleusentore sind insbesondere manuell, halbautomatisch oder vollautomatisch ansteuerbar. Die ersten und zweiten Schleusentore sind insbesondere unabhängig voneinander ansteuerbar.

Die Bondkammer und/oder das Zuordnungsmodul/die Zuordnungsmodule sind einzeln evakuierbar. Die Bondkammer und/oder die Zuordnungsmodule können insbesondere auf einen Druck kleiner als 1 bar, vorzugsweise weniger als 10⁻³ mbar, noch bevorzugter weniger als 10⁻⁵ mbar, am bevorzugtesten weniger als 10⁻⁸ mbar evakuiert werden. Denkbar ist auch eine Beaufschlagung mit Überdruck, insbesondere durch das Einpumpen und/oder Einlassen eines Inertgases. Die Bondkammer und/oder die Zuordnungsmodule können anschließend mit Gasen oder Gasgemischen mit einem Druck größer als 1 bar, vorzugsweise größer als 2 bar, noch bevorzugter größer als 3 bar geflutet, vorzugsweise gespült, werden. Denkbar ist auch eine, insbesondere ausschließliche, Verwendung der Bondkammer und/oder der Zuordnungsmodule bei Umgebungsdruck von 1 bar.

Die Bondkammer wird vor allem bei der Verwendung eines Thermokompressionsbonders mit Inertgasen oder Gasen, welche die erneute Oxidbildung verhindern, zumindest hinauszögern oder vorzugsweise sogar rückgängig machen, gespült. Denkbar ist auch die Verwendung beliebiger Gasgemische. Vorzugsweise werden folgende Gase oder Gasgemische aus den genannten Gasen verwendet:
- Argon und/oder
- Helium und/oder
- Wasserstoff und/oder
- Kohlendioxid und/oder
- Formiergas und/oder
- Ameisensäure und/oder
- SF6.

Jedes der Zuordnungsmodule verfügt insbesondere über mindestens ein, vorzugsweise zwei, noch bevorzugter drei, am allerbevorzugtesten mehr als drei, Messgeräte, mit deren Hilfe Ausrichtungsmarkierungen und/oder charakteristische Substratmerkmale vermessen werden können. Bei den Messgeräten handelt es sich vorzugsweise um optische Messgeräte, noch bevorzugter um Mikroskope.

In einer besonderen erfindungsgemäßen Ausführungsform handelt es sich um Messgeräte zur Kantenvermessung. Ein derartiges Gerät zur Kantenvermessung wird beispielsweise in der Druckschrift WO2013185803A1 erwähnt. Die Messgeräte sind in der Lage, ein, insbesondere vollumfängliches (bezogen auf den Seitenumfang des Substrats), Kantenprofil zu erstellen. Dieses Kantenprofil besitzt insbesondere eine Auflösung mindestens im Mikro-, vorzugsweise mindestens im Nanometerbereich. Die Kante eines jeden Substrats ist einzigartig, insbesondere auf Grund einer bevorzugten Bearbeitung des Substrats und/oder der Herstellung des Substrats aus einem Ingot. Durch diese Einzigartigkeit erhält man ein vollumfängliches, insbesondere kreisrundes Profil der Substratkante. Dieses Profil könnte auch dadurch definiert werden, dass der Durchmesser des Substrats als Funktion eines Drehwinkels unterschiedlich ist.

Die Auflösung der Messgeräte ist insbesondere größer als 1 mm, vorzugsweise größer als 100 µm, noch bevorzugter größer als 1 µm, am bevorzugtesten größer als 100 nm, am allerbevorzugtesten größer als 10 nm.

Eine Vergrößerung der Messgeräte, insbesondere der Mikroskope, ist insbesondere besser als der Faktor 1, vorzugsweise besser als der Faktor 10, noch bevorzugter besser als der Faktor 1000, am bevorzugtesten bessre als der Faktor 10⁵, am allerbevorzugtesten besser als der Faktor 10⁷.

Die Messgeräte sind insbesondere translatorisch und/oder rotatorisch verstellbar, sodass sie innerhalb der Zuordnungsmodule frei verschoben und/oder rotiert werden können. Dadurch ist eine Anpassung der Messgeräte an die Dimension der Substrate und/oder eine Vorpositionierung zu den Ausrichtungsmarkierungen und/oder charakteristischen Substratmerkmalen möglich.

Insbesondere wird bei einer Substratart und/oder einem identischen Prozess eine derartige Vorpositionierung der Messgeräte nur einmal durchgeführt, sodass die zu vermessenden Teile des Substrats nach dem Beladen des Substrats in die Schleuse bereits im Sichtfeld (engl.: fieldof-view, FOV) angeordnet sind. Zusätzlich werden die zu vermessenden Ausrichtungsmarkierungen und/oder charakteristischen Substratmerkmale in den Tiefenbereich (engl.: depth-of-focus, DOF) gebracht, um eine scharfe Abbildung mit größtmöglicher Auflösung zu erhalten.

Der Transport der Substrate aus den Zuordnungsmodulen in die Bondkammer und zurück wird vorzugsweise durch einen Roboter durchgeführt. Der Roboter kann sich dabei entweder in einer Schleuse oder der Bondkammer befinden. Denkbar ist auch, dass sich zwischen der Schleuse und der Bondkammer ein zwischengeschobenes Robotermodul befindet. Sollten mehrere Schleusen vorhanden sein, ist es denkbar, einen Roboter in jeder Schleuse zu positionieren. Besonders bevorzugt wird allerdings die Positionierung des Roboters in der Bondkammer, sodass ein Zugriff auf jede einzelne Schleuse durch einen einzigen Roboter erfolgen kann. Der Roboter ist vorzugsweise auch in der Lage, an zur Bondkammer gegenüberliegende Enden der Zuordnungsmodule zu gelangen, sodass die Substrate vorzugsweise nicht nur aus den Zuordnungsmodulen in die Bondkammer, sondern auch aus jeweils einer den Zuordnungsmodulen vorgelagerten Waferbox, insbesondere einem FOUP, in die Zuordnungsmodule geladen werden können.

In besonderen Ausführungsformen lädt der Roboter die Substrate allerdings nur aus den Schleusen in die Bondkammer, während die Beladung der Schleusen von außen insbesondere durch einen weiteren, insbesondere externen, Roboter erfolgt.

Unter einem Roboter ist jede Art von Maschine zu verstehen, die in der Lage ist die Substrate aufzunehmen, eine bestimmte Strecke zu transportieren und wieder abzugeben.

In der Bondkammer befindet sich eine Bondvorrichtung, insbesondere ein Fusionsbonder, noch bevorzugter ein Thermokompressionsbonder. Die Bondvorrichtung besteht aus einem unteren, ersten Probenhalter und einem oberen, zweiten Probenhalter. Die Bondkammer verfügt ebenfalls über mehrere Messeinrichtungen, insbesondere Mikroskope. Die Messeinrichtungen der Bondkammer sind insbesondere auf die Peripherie oder die peripheren Bereiche (Seitenumfang) der geladenen Substrate eingestellt, sodass eine Vermessung der charakteristischen Substratmerkmale erfolgen kann. Durch eine Beschränkung der Vermessung auf die charakteristischen Substratmerkmale kann auf die Vermessung der Ausrichtungsmarkierungen in der Bondvorrichtung verzichtet werden. Hieraus ergeben sich mehrere Vorteile:
a) Die Messung kann auch während der Annäherung der Substrate und bis zur Kontaktierung erfolgen,
b) Die Bondvorrichtung kann kleiner gebaut werden, so dass weniger Volumen mit einer für das Bonden definierten Atmosphäre oder einem definierten Gasdruck beaufschlagt werden muss,
c) Das Bonden wird beschleunigt.

Durch die erfindungsgemäße, in dem/n Zuordnungsmodul(en) stattgefundene Vermessung der Ausrichtungsmarkierungen in Bezug zu den charakteristischen Substratmerkmalen wird eine Annäherung (Z-Richtung) und ein Bonden der Substrate bei gleichzeitiger Vermessung und in-situ Überwachung an Hand der charakteristischen Substratmerkmale ermöglicht, wobei die Ausrichtungsmarkierungen somit (indirekt vermessen) ausgerichtet werden. Die Position der Ausrichtungsmarkierungen in der X-Y-Ebene wird somit an Hand der X-Y-Positionen der charakteristischen Substratmerkmale berechnet.

### Der Prozess

Alle Substrate können vor der Beladung in die Schleusen einer Vorbehandlung unterzogen werden. Bei den Vorbehandlungen kann es sich insbesondere um
- Reinigungsprozesse, insbesondere die Entfernung von Oxiden, und/oder
- Amorphisierung der Oberfläche und/oder
- Ätzprozesse und/oder
- Lithographische Prozesse, insbesondere
   ∘ Photolithographische Prozesse
   ∘ Imprintlithographieprozesse
   handeln. Eine Oxidentfernung und/oder Amorphisierung erfolgt vorzugsweise durch eine Anlage, wie sie in der Druckschrift PCT/EP2014/063303 erwähnt wird.

In einem erfindungsgemäßen ersten Schritt erfolgt ein Beladen einer ersten Schleuse (allgemeiner: Zuordnungsmodul). Zunächst wird das zweite Schleusentor, das die Schleuse mit der Bondkammer verbindet, geschlossen. Daraufhin wird das erste Schleusentor, das die Umgebung mit der Schleuse verbindet, geöffnet. Es erfolgt eine Beladung der ersten Schleuse mit einem ersten Substrat. Nach der Beladung eines ersten Substrats in die erste Schleuse wird das erste Schleusentor wieder geschlossen.

Nachdem Verschließen der Schleuse beginnt ein Evakuierungsvorgang. Die Evakuierung ist somit insbesondere auf die relativ kleine und möglichst kompakt konstruierte Schleuse begrenzt. Erfindungsgemäß und daher bevorzugt wird während der Evakuierung eine Vermessung der Substratoberfläche des geladenen Substrats durchgeführt.

Mehrere Messgeräte vermessen die X-Positionen und Y-Positionen von ersten und zweiten (und ggf. weiteren) Ausrichtungsmarkierungen auf der Substratoberfläche sowie mindestens ein, vorzugsweise mindestens zwei, am bevorzugtesten mindestens drei, charakteristische Substratmerkmale. Die Messgeräte sind/werden untereinander so kalibriert, dass sie die exakte Position und/oder die Orientierung der Ausrichtungsmarkierungen in Bezug zu den charakteristischen Substratmerkmalen ermitteln können. Damit sind die Positionen und ggf. die Orientierungen der Ausrichtungsmarkierungen in Bezug auf die charakteristischen Substratmerkmale eindeutig bestimmt (Zuordnung)

Diese Daten/Informationen werden bezogen auf das jeweilige Substrat von einer Firm- und/oder Hard- und/oder Software gespeichert.

Die Vermessung sollte erfindungsgemäß nicht länger dauern als die Evakuierung der Schleuse, sodass der Prozess bezüglich des Durchsatzes optimiert durchgeführt werden kann. Es wird durch die Vermessung insbesondere keine zusätzliche Prozesszeit beansprucht.

Während des erfindungsgemäß ersten Prozessschritts kann, insbesondere simultan, in eine weitere, insbesondere zweiten Schleuse (allgemeiner: Zuordnungsmodul), ein weiteres, insbesondere zweites Substrat geladen und auf dieselbe Weise prozessiert werden wie in der ersten Schleuse.

Soweit ein einziger Roboter für den Transport der Substrate verwendet wird, kann der Transport der Substrate nicht gleichzeitig erfolgen. Erfindungsgemäß ist es bevorzugt, dass immer nur ein Roboter Zugang zu der Bondanlage, insbesondere zu Probenhaltern zur Aufnahme der Substrate, erhält. Dadurch entsteht eine prozessbedingte Verzögerung zwischen dem ersten und dem zweiten Substrat. Das Laden eines Substrats, die Evakuierung einer Schleuse, und das Entladen des Substrats in die Bondkammer wird somit nicht vollständig synchron ablaufen, jedoch vorzugsweise überwiegend. Das Laden des zweiten Substrats kann somit als dritter Prozessschritt bezeichnet werden.

In einem erfindungsgemäßen zweiten Prozessschritt wird das zweite Schleusentor der ersten Schleuse zur Bondkammer geöffnet. Die Bondkammer besitzt zu diesem Zeitpunkt insbesondere einen Druck von weniger als 1 bar, vorzugsweise weniger als 10⁻³ mbar, noch bevorzugter weniger als 10⁻⁵ mbar, am bevorzugtesten weniger als 10⁻⁸ mbar. Vorzugsweise wird die Bondkammer nach einer einmaligen Evakuierung während einer Vielzahl von Bondvorgängen nicht mehr geflutet. Dies ist erst wieder im Fall einer Unterbrechung des Bondens, insbesondere für Wartungs- und/oder Reparaturarbeiten, notwendig.

Ein Roboter nimmt das bereits vermessene und zugeordnete erste Substrat aus der ersten Schleuse auf und positioniert es auf einem der beiden Probenhalter in der Bondkammer der Bondinganlage, Der Roboter führt dabei vorzugsweise eine Vorpositionierung (engl.: pre-alignment) durch. Nachdem das Substrat aus der Schleuse entnommen wurde, können das zweite Schleusentor wieder geschlossen und verriegelt und das erste Schleusentor geöffnet werden, um ein neues Substrat in die erste Schleuse zuladen. Ein neuer Prozess kann somit schon beginnen, wenn der alte noch nicht abgeschlossen ist.

In einem erfindungsgemäßen dritten Prozessschritt wird ein zweites Substrat in eine zweite Schleuse geladen. Die zweite Schleuse kann identisch zur ersten Schleuse konstruiert sein. Denkbar ist es insbesondere, dass die zweiten Messgeräte eine einer ersten Messrichtung der Messgeräte der ersten Schleuse entgegengesetzte, zweite Messrichtung besitzen. Somit kann in Bezug auf das erste Substrat die gegenüberliegende Seite, vorzugsweise die Unterseite, des zweiten Substrats vermessen werden. Der Roboter findet das zweite Substrat dann bereits in der für das Bonden mit dem ersten Substrat korrekten Orientierung vor. Ein Substrat kann insbesondere in einem sogenannten Flip-Modul gedreht werden, bevor es in die Schleuse geladen wird. Dabei handelt es sich um ein Modul, das ein Substrat, insbesondere große Substrate, um 180° drehen können. Die Drehung erfolgt dabei um eine Achse, die innerhalb der Substratebene liegt.
Denkbar ist auch eine zusätzliche Drehung um eine Achse, die normal auf die Substratoberfläche steht, um einen Vorausrichtungsvorgang (engl.: pre-alignment) durchzuführen. Dieser Vorausrichtungsvorgang erfolgt entweder im Flip Modul oder in einem eigenen Vorausrichter (engl.: prealigner) durchgeführt werden. Denkbar ist aber auch die Verwendung eines Roboters, der ein fixiertes Substrat um 180° drehen kann. Das Laden, Vermessen und Entladen des zweiten Substrats erfolgt simultan oder zweitverzögert zum zweiten Prozessschritt.

Es ist erfindungsgemäß denkbar, dass weitere Substrate in weiteren Schleusen zur Bondkammer zugeführt werden, entweder um mehr als zwei Substrate zu Bonden oder um weitere Substrate für den nächsten Bondvorgang vorzubereiten und somit den Durchsatz zu erhöhen.

In einem erfindungsgemäßen vierten Prozessschritt erfolgt eine Vermessung der charakteristischen Substratmerkmale der Substrate durch die Messgeräte in der Bondkammer. Ein wesentlicher erfindungsgemäßer Vorteil, insbesondere zu Ausrichtungsanlagen, wie sie in den Druckschriften PCT/EP2013/075831, WO2014202106A1 oder US6214692B1 erwähnt werden, besteht darin, dass die Ausrichtung der Substrate nunmehr ausschließlich anhand der charakteristischen Substratmerkmale erfolgt und dafür extrem kurze Verfahrwege notwendig sind. Dennoch werden die Ausrichtungsmarkierungen der Substrate durch den Ausrichtungsprozess mittelbar zur Deckung gebracht, da die Relation zwischen den Ausrichtungsmarkierungen und den charakteristischen Substratmerkmalen durch die erfindungsgemäße Vermessung in den Zuordnungsmodulen, insbesondere Schleusen, bekannt ist. Die beiden zu bondenden Substrate sind vorzugsweise bereits durch den Roboter vorpositioniert, damit die charakteristischen Substratmerkmale von den Messgeräten zur genauen Ausrichtung der Substrate diese leichter auffinden. Der Roboter versucht dabei mit seiner technisch vorgegebenen Genauigkeit eine möglichst gute Annäherung der charakteristischen Substratmerkmale der Substrate zueinander zu erreichen. Dazu können auch Daten aus der Vermessung der Substrate in der Schleuse herangezogen werden.

Die Feinjustierung (genaue Ausrichtung) der charakteristischen Substratmerkmale zueinander erfolgt dann mittels der in X-Richtung und Y-Richtung bewegbaren, insbesondere verschiebbaren und rotierbaren, Probenhalter. Dabei werden die Position und/oder die Orientierung der charakteristischen Substratmerkmale während der Verschiebung der Substrate zueinander kontinuierlich vermessen und an eine Firm- und/oder Hard- und/oder Software weitergeleitet, die aus den übermittelten Daten die neue Position der Probenhalter und damit der Substrate berechnet.

Ein erfindungsgemäßer Aspekt liegt insbesondere darin, dass sich die (insbesondere alle) charakteristischen Substratmerkmale an der Peripherie, insbesondere am äußeren Rand (seitlicher Umfangsrand beziehungsweise Außenkontur in der X-Y-Ebene) der Substrate, noch bevorzugter an deren äußeren Oberflächen, befinden und damit leicht zugänglich sind. Erfindungsgemäß werden zwar insbesondere die charakteristischen Substratmerkmale erfasst, aber durch die, in den Zuordnungsmodulen erfolgte Zuordnung referenzierbaren, Ausrichtungsmarkierungen zueinander ausgerichtet.

Die Zuordnung und Berechnung der Positionierung kann insbesondere durch Vektorrechnung in einer zentralen Steuerungseinrichtung erfolgen.

Soweit Verfahrensmerkmale offenbart sind, sollen diese auch vorrichtungsgemäß als offenbart gelten und umgekehrt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1: eine schematische, nicht maßstabsgetreue Aufsicht auf eine Ausführungsform eines Clusters mit einer erfindungsgemäßen Vorrichtung,
- Figur 2a: eine schematische Aufsicht auf eine Ausführungsform der Substrat mit Ausrichtungsmarkierungen und charakteristischen Merkmalen,
- Figur 2b: eine schematische Aufsicht gemäß Figur 2a bei einem erfindungsgemäßen Zuordnungsschritt,
- Figur 2c: eine schematische Aufsicht gemäß Figur 2a bei einem erfindungsgemäßen Ausrichtungsschritt,
- Figur 3: eine schematische Aufsicht auf eine Messeinrichtung zur Vermessung der Substrate und
- Figur 4: ein erfindungsgemäßer Prozessfluss.
In den Figuren sind gleiche oder gleichwirkende Teile mit einheitlichen Bezugszeichen gekennzeichnet, wobei die Größenverhältnisse zur Veranschaulichung zur Veranschaulichung dienen und daher nicht maßstabsgetreu sind.

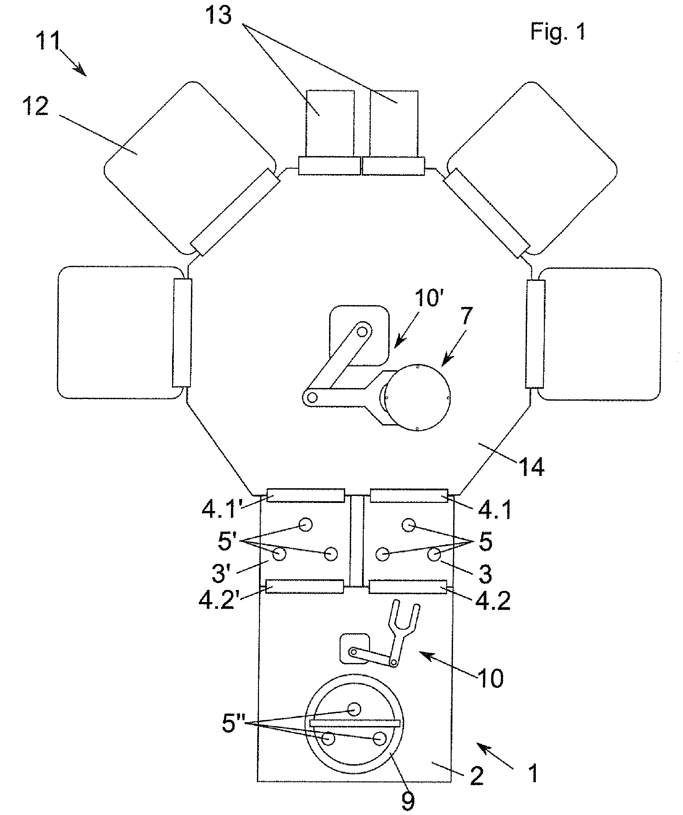

Die Figur 1 zeigt eine Clusteranlage11, die folgende Einrichtungen aufweist:
- unterschiedliche und/oder gleichartige Module 12 zur Bearbeitung von Substraten 7, 7',
- eine, hier als Modul der Clusteranlage 11 ausgestaltete, Vorrichtung 1 mit ersten Schleusentoren 4, 4', zwei Zuordnungsmodulen 3, 3' und einer Bondkammer 2,
- einer, insbesondere evakuierbaren, Transferkammer 14,
- ein Roboter 10', der für das Bewegen (insbesondere Laden) der Substrate 7, 7' verwendet wird und
- Foups 13 zur Zuführung der Substrate 7, 7' in die Transferkammer 14 der Clusteranlage 11.

Die erfindungsgemäße Vorrichtung 1 kann allerdings auch unabhängig von einem Cluster 11 betrieben werden.

Die Module 12 können insbesondere Einrichtungen zur Behandlung (Aufbringung von Schichten, Amorphisierung, Plasmaaktivierung, Reinigung, insbesondere Oxidentfernungen etc.) von Oberflächen, insbesondere in der Bondkammer 2 zu kontaktierende und verbondende Substratoberflächen 7o, 7o' der Substrate 7, 7'.

Der Bondkammer 2 sind zwei als Schleusen ausgebildete erste und zweite Zuordnungsmodule 3, 3' vorgeschaltet. Die Schleusen sind jeweils über erste Schleusentore 4.1, 4.1' mit der Transferkammer 14 (oder im Falle einer eigenständigen Vorrichtung 1 mit der Umgebung) und über zweite Schleusentore 4.2, 4.2' mit der Bondkammer 2 verbunden.

In den Schleusen befinden sich mehrere, verschieb-und/oder rotierbare Messgeräte 5, 5', mit denen erste und zweite Ausrichtungsmarkierungen 8, 8', sowie erste und zweite charakteristischen Substratmerkmale 9, 9' der ersten und zweiten Substrate 7, 7' vermessen werden.

Durch Justierung der Messgeräte 5, 5' zueinander kann jeweils eine eindeutige X-Y-Position und Orientierung der Ausrichtungsmarkierungen 8, 8' zu den charakteristischen Substratmerkmalen 9. 9' bestimmt werden. Die Zuordnung wird mittels Vektorrechnung in einer zentralen Steuerungseinrichtung berechnet und in Bezug auf die jeweiligen ersten und zweiten Substrate 7, 7' gespeichert.

Ein Roboter 10 transportiert die vermessenen Substrate 7, 7' nach Öffnung der zweiten Schleusentore 4.2, 4.2' aus den jeweiligen Schleusen in die Bondkammer 2 und legt sie jeweils auf nicht dargestellten ersten und zweiten Probenhaltern in der Bondvorrichtung 6 in einer vorausgerichteten Position ab.

Durch Messgeräte 5" werden die X-Y-Positionen der charakteristischen Substratmerkmale 9, 9' ermittelt. Durch die vorher erfolgte Zuordnung wird eine Ausrichtung der charakteristischen Substratmerkmale 9, 9' durchgeführt, wobei die Ausrichtungsmarkierungen 8, 8' durch entsprechende Bewegung der Probenhalter optimal zueinander ausgerichtet werden.

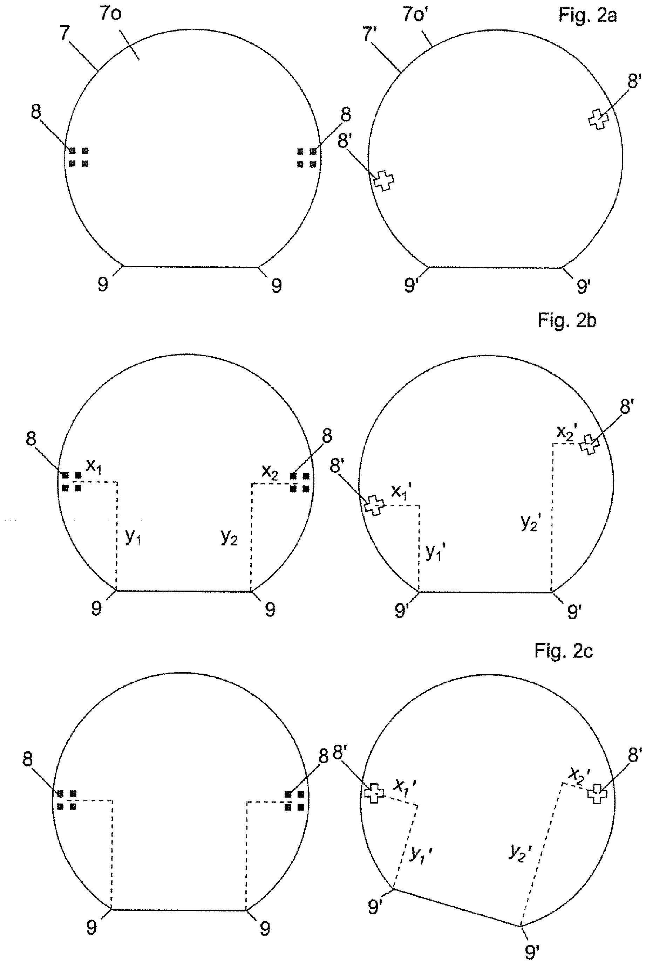

Figur 2a zeigt eine schematische, nicht maßstabsgetreue Oberansicht zweier Substrate 7, 7' (links: erstes Substrat 7; rechts: zweites Substrat 7'). Die Substrate 7, 7' besitzen an ihren Substratoberflächen 7o, 7o' jeweils zwei erste und zwei zweite Ausrichtungsmarkierungen 8, 8' sowie jeweils zwei erste und zwei zweite charakteristische Substratmerkmale 9, 9'. Es können auch jeweils mehr als zwei Ausrichtungsmarkierungen 8, 8' und/oder jeweils mehr als zwei charakteristische Substratmerkmale 9, 9' vorgesehen sein.

Insbesondere sind die Schnittpunkte bzw. Übergänge der flachen Seite (flat) der Substrate 7, 7' mit dem Kreisumfang der Substrate 7, 7' eindeutige (bei einer Vielzahl von Wafern vorhandene) charakteristische Substratmerkmale 9, 9' der Substrate 7, 7'. Der Vorteil dieser charakteristische Substratmerkmale 9, 9' ist, dass jedes Substrat genau zwei solche charakteristischen Substratmerkmale 9, 9' aufweist.

Die zweiten Ausrichtungsmarkierungen 8' des zweiten Substrats 7' wurden absichtlich stark abweichend von einer als ideal anzunehmenden Position dargestellt um den erfindungsgemäßen Effekt besser darstellen zu können.

Die Figur 2b zeigt die durch Vermessung ermittelten X- und Y-Positionen x1, y1, x2, y2 der ersten Ausrichtungsmarkierungen 8 des ersten Substrats 7 in Bezug zu den ersten charakteristischen Substratmerkmalen 9 sowie die X- und Y-Positionen x1', y1', x2', y2' der zweiten Ausrichtungsmarkierungen 8' des zweiten Substrats 7' in Bezug zu den zweiten charakteristischen Substratmerkmalen 9'. Hierdurch kann zumindest in der durch die Substratoberflächen 7o, 7o' definierten X-Y-Ebene eine Zuordnung der charakteristischen Substratmerkmale 9, 9' zu den Ausrichtungsmarkierungen 8, 8' erfolgen.

Die Figur 2c zeigt die Orientierung der Substrate 7, 7' nach einem erfindungsgemäßen Ausrichtungsprozess der beiden Substrate 7, 7' durch Messung der X-Y-Positionen der charakteristischen Substratmerkmale 9, 9' nach Transfer der Substrate 7, 7' in die Bondkammer 2. Nach Ausrichtung und Kontaktierung sowie nach dem Bonden sind die Ausrichtungsmarkierungen 8, 8' deckungsgleich bzw. in Z-Richtung fluchtend zueinander angeordnet. Die Figur 2c zeigt aus Darstellungszwecken nur die Orientierung der Substrate 7, 7' in der X-Y-Ebene, ohne die Substrate 7, 7' übereinander anzuordnen.

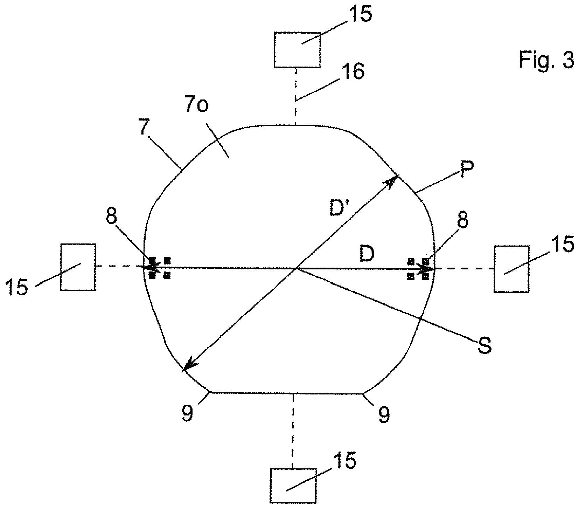

Figur 3 zeigt stark schematisiert sich im Schnittpunkt S schneidende, voneinander (übertrieben dargestellt) abweichende Durchmesser D, D' eines der Substrate 7, 7'. Die Asymmetrie der Substrate beziehungsweise der Durchmesser unter verschiedenen Drehwinkeln beträgt in der Realität nur um wenige Mikro- oder Nanometer. Gemäß einer bevorzugten Ausführungsform der Erfindung wird das Profil eines sich drehenden, insbesondere im Schwerpunkt zentrierten und gelagerten, Substrats 7 durch Messgeräte 15 vermessen werden.

Diese Messgeräte verwenden insbesondere ein Interferometer, um die Position von der Quelle zur Kante der Substrate 7, 7', insbesondere mittels eines Laserstrahls 16, zu vermessen. Durch die gezielte Positionierung mehrerer solcher Interferometer 15, insbesondere in äquidistanten Winkelabständen, ist eine kontinuierliche Aufnahme eines Substratprofils P möglich. Dieses Profil wird insbesondere als ein weiteres charakteristisches Substratmerkmal 9" zur genauen Ausrichtung der Substrate beim Bonden verwendet.

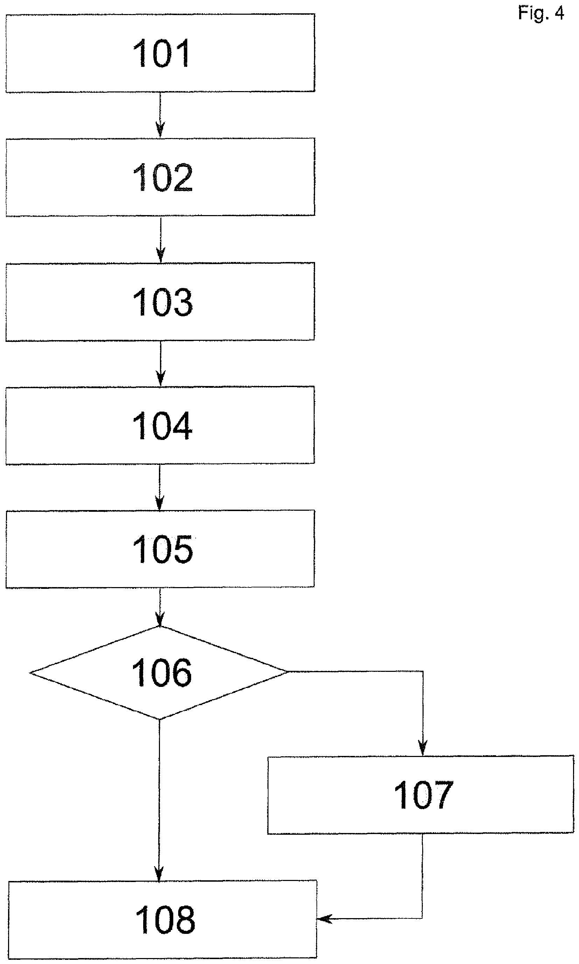

Die Figur 4 zeigt einen schematischen Prozessfluss für eines der beiden Substrate 7,7'. Zuerst (Schritt 101) können entsprechende Vorbehandlungsschritte an einem der Substrate 7, 7', in einer Clustervorrichtung 11 insbesondere in den Modulen 12, erfolgen, sofern die erfindungsgemäße Vorrichtung 1 teil eines Clustersystems 11 ist. Sollte die erfindungsgemäße Vorrichtung 1 nicht Teil eines Clusters 11 sein, so können die optionalen Vorbehandlungsschritte in voneinander getrennten Modulen stattfinden.

Danach (Schritt 102) wird das Substrat 7,7', insbesondere mit Hilfe eines Roboters 10', in eine der beiden Schleusen 3,3' geladen.

Anschließend (Schritt 103) erfolgt eine Evakuierung und erfindungsgemäß, insbesondere gleichzeitige, Vermessung der charakteristischen Substratmerkmale 9, 9' in Bezug zu den Ausrichtungsmarkierungen 8, 8' (Zuordnung).

Danach (Schritt 104) erfolgt der Transfer in die Bondkammer 2, insbesondere durch einen Roboter 10.

Der Roboter 10 versucht die Substrate 7, 7' bereits mit möglichst hoher Präzision abzulegen (Schritt 105), insbesondere so, dass nur mehr eine z-Annäherung der beiden Substrate 7, 7', also ein Bondvorgang, erfolgen muss.

Sofern die Ausrichtegenauigkeit durch den Roboter 10 nicht ausreicht (Schritt 106), wird eine präzisere Ausrichtung anhand der bereits vorvermessenen charakteristischen Substratmerkmale 9, 9' erfolgen (Schritt 107). In einem letzten Schritt (Schritt 108) erfolgt ein Verbonden der beiden Substrate 7, 7'.

Der so erzeugte Substratstapel kann dann wieder aus dem Bondmodul entfernt werden. Vorzugsweise erfolgt das Entladen über eine der beiden Schleusen 3, 3', während in der anderen Schleuse 3,3' bereits ein neues Substrate 7, 7' geladen werden kann.

### Bezugszeichenliste

- 1: Vorrichtung
- 2: Bondkammer
- 3, 3': Zuordnungsmodule, insbesondere Schleusen
- 4.1, 4.1': erste Schleusentore
- 4.2, 4.2': zweite Schleusentore
- 5, 5', 5": Messgeräte, insbesondere Mikroskope
- 6: Bondvorrichtung
- 7, 7': Substrate
- 7o, 7o': Substratoberflächen
- 8, 8': Ausrichtungsmarkierungen
- 9, 9': Charakteristische Substratmerkmale
- 10: Roboter
- 11: Cluster
- 12: Modul
- 13: Foup
- 14: Transferkammer
- 15: Interferometer
- 16: Laserstrahl
- D, D': Durchmesser
- S: Schwerpunkt
- P: Substratprofil

## Patentansprüche

1. Verfahren zum Ausrichten eines mindestens zwei erste Ausrichtungsmarkierungen (8) aufweisenden ersten Substrats (7) mit einem mindestens zwei zweite Ausrichtungsmarkierungen (8') aufweisenden zweiten Substrat (7'), wobei
- durch eine erste Zuordnung die ersten Ausrichtungsmarkierungen (8) mindestens zwei ersten charakteristischen Ausrichtungsmerkmalen (9) des ersten Substrats (7) in einer X-Richtung und in einer Y-Richtung zugeordnet werden, wobei durch Vermessung der ersten Ausrichtungsmarkierungen (8) in Bezug zu den ersten charakteristischen Ausrichtungsmerkmalen (9) erste X- und Y-Positionen (X1, Y1, X2, Y2) ermittelt werden,
- durch eine zweite Zuordnung die zweiten Ausrichtungsmarkierungen (8') mindestens zwei zweiten charakteristischen Ausrichtungsmerkmalen (9') des zweiten Substrats (7') in einer X-Richtung und in einer Y-Richtung zugeordnet werden, wobei durch Vermessung der zweiten Ausrichtungsmarkierungen (8') in Bezug zu den zweiten charakteristischen Ausrichtungsmerkmalen (9') zweite X- und Y-Positionen (X1', Y1', X2', Y2') ermittelt werden,
- wobei durch eine Ausrichtung die ersten (8) und zweiten Ausrichtungsmarkierungen (8') mittels der ersten und zweiten charakteristischen Ausrichtungsmerkmale (9, 9') zueinander in X- und Y-Richtung ausgerichtet werden, wobei anhand der ersten X- und Y-Positionen (X1, Y1, X2, Y2) und der zweiten X- und Y-Positionen (X1', Y1', X2', Y2') die Ausrichtung der Substrate (7, 7') derart erfolgt, dass die Ausrichtungsmarkierungen (8, 8') deckungsgleich angeordnet sind, wobei nach der ersten und zweiten Zuordnung und vor der Ausrichtung ein Transfer der Substrate (7, 7') in ein Bondmodul erfolgt.

2. Verfahren nach Anspruch 1, wobei im Bondmodul die Ausrichtung, vorzugsweise unter einem Gasdruck kleiner 1 bar, durchgeführt wird.

3. Verfahren nach einem der Ansprüche 1 oder 2, bei dem die erste Zuordnung in einem ersten, insbesondere als Schleuse ausgebildeten, Zuordnungsmodul (3) und die zweite Zuordnung, insbesondere parallel zur ersten Zuordnung, in einem zweiten, insbesondere als Schleuse ausgebildeten, Zuordnungsmodul (3') erfolgen.

4. Verfahren nach wenigstens einem der Ansprüche 2 oder 3, wobei vor der Ausrichtung, insbesondere im ersten und/oder zweiten Zuordnungsmodul, vorzugsweise während der Zuordnung, der Gasdruck reduziert wird, vorzugsweise auf einen Gasdruck von weniger als 1 bar, noch bevorzugter weniger als 10⁻³ mbar, noch bevorzugter weniger als 10⁻⁵ mbar, am bevorzugtesten weniger als 10⁻⁸ mbar.

5. Verfahren nach wenigstens einem der vorhergehenden Ansprüche, wobei die ersten und/oder zweiten charakteristischen Ausrichtungsmerkmale (9, 9') jeweils am Seitenrand des ersten und zweiten Substrats (7, 7') angeordnet sind.

6. Verfahren nach wenigstens einem der vorhergehenden Ansprüche, wobei eines oder mehrere der nachfolgend aufgeführten Merkmale als erste und/oder zweite charakteristische Ausrichtungsmerkmale (9, 9') verwendet werden:
• kreisförmiger Substratrandabschnitt und/oder
• flacher Substratrandabschnitt und/oder
• kerbartig geformter Substratrandabschnitt und/oder
• Schnittpunkte der vorgenannten Merkmale und/oder
• Schnittpunkte von Tangenten der vorgenannten Merkmale.

7. Vorrichtung zum Ausrichten eines mindestens zwei erste Ausrichtungsmarkierungen (8) aufweisenden ersten Substrats (7) mit einem mindestens zwei zweite Ausrichtungsmarkierungen (8') aufweisenden zweiten Substrat (7'), mit
- einem ersten Zuordnungsmodul (3) zur Zuordnung der ersten Ausrichtungsmarkierungen (8) zu mindestens zwei ersten charakteristischen Ausrichtungsmerkmalen (9) des ersten Substrats (7) in einer X-Richtung und in einer Y-Richtung, wobei durch Vermessung der ersten Ausrichtungsmarkierungen (8) in Bezug zu den ersten charakteristischen Ausrichtungsmerkmalen (9) erste X- und Y-Positionen (X1, Y1, X2, Y2) ermittelt werden,
- einem zweiten Zuordnungsmodul (3') zur Zuordnung der zweiten Ausrichtungsmarkierungen (8') zu mindestens zwei zweiten charakteristischen Ausrichtungsmerkmalen (9') des zweiten Substrats (7') in einer X-Richtung und in einer Y-Richtung, wobei durch Vermessung der zweiten Ausrichtungsmarkierungen (8') in Bezug zu den zweiten charakteristischen Ausrichtungsmerkmalen (9') zweite X- und Y-Positionen (X1', Y1', X2', Y2') ermittelt werden,
- einem, insbesondere als Bondmodul ausgebildeten, Ausrichtungsmodul zur Ausrichtung der ersten (8) und zweiten Ausrichtungsmarkierungen (8') mittels der ersten und zweiten charakteristischen Ausrichtungsmerkmale (9, 9') zueinander in X- und Y-Richtung, wobei anhand der ersten X- und Y-Positionen (X1, Y1, X2, Y2) und der zweiten X- und Y-Positionen (X1', Y1', X2', Y2') die Ausrichtung der Substrate (7, 7') derart erfolgt, dass die Ausrichtungsmerkmale (8, 8') deckungsgleich angeordnet sind, wobei nach der ersten und zweiten Zuordnung und vor der Ausrichtung ein Transfer der Substrate (7, 7') in ein Bondmodul erfolgt.

8. Vorrichtung nach Anspruch 7, wobei die Zuordnungsmodule als Schleusen zu dem Ausrichtungsmodul ausgebildet sind.

9. Vorrichtung nach Anspruch 7 oder 8, mit
- ersten, insbesondere jeweils in den Zuordnungsmodulen (3, 3') angeordneten, Erfassungsmitteln zur Erfassung von X-Koordinaten und Y-Koordinaten der ersten und zweiten Ausrichtungsmarkierungen (8, 8'),
- zweiten, insbesondere jeweils in den Zuordnungsmodulen (3, 3') angeordneten, Erfassungsmitteln zur Erfassung von X-Koordinaten und Y-Koordinaten der ersten und zweiten charakteristischen Ausrichtungsmerkmale (9, 9'),
- dritten, insbesondere im Ausrichtungsmodul angeordneten, Erfassungsmitteln (15) zur Erfassung von X'-Koordinaten und Y'-Koordinaten der ersten und zweiten charakteristischen Ausrichtungsmerkmale (9, 9').

## Claims

1. A method for the alignment of a first substrate (7) comprising at least two first alignment marks (8) with a second substrate (7') comprising at least two second alignment marks (8'), wherein
- by means of a first assignment, the first alignment marks (8) are assigned to at least two first characteristic alignment features (9) of the first substrate (7) in an X-direction and in a Y-direction, wherein first X- and Y-positions (X1, Y1, X2, Y2) are determined by measuring the first alignment marks (8) in relation to the first characteristic alignment features (9),
- by means of a second assignment, the second alignment marks (8') are assigned to at least two second characteristic alignment features (9') of the second substrate (7') in an X-direction and in a Y-direction, wherein second X- and Y-positions (X1', Y1', X2', Y2') are determined by measuring the second alignment marks (8') in relation to the second characteristic alignment features (9'),
- by means an alignment, the first (8) and second alignment marks (8') are aligned in relation to one another in an X- and Y-direction by means of the first and second characteristic alignment features (9, 9'), wherein the alignment of the substrates (7, 7') takes place with the aid of the first X- and Y-positions (X1, Y1, X2, Y2) and the second X- and Y-positions (X1', Y1', X2', Y2'), in such a way that the alignment marks (8, 8') are arranged congruent, wherein a transfer of the substrates (7, 7') into a bonding module takes place after the first and second assignment and before the alignment.

2. The method according to claim 1, wherein the alignment is carried out in the bonding module, preferably under a gas pressure less than 1 bar.

3. The method according to any one of claims 1 or 2, wherein the first assignment takes place in a first assignment module (3), constituted in particular as a lock, and the second assignment takes place, in particular in parallel with the first assignment, in a second assignment module (3'), constituted in particular as a lock.

4. The method according to at least one of claims 2 or 3, wherein, before the alignment, in particular in the first and/or second assignment module, preferably during the assignment, the gas pressure is reduced, preferably to a gas pressure of less than 1 bar, more preferably less than 10⁻³ mbar, still more preferably less than 10⁻⁵ mbar, most preferably less than 10⁻⁸ mbar.

5. The method according to at least one of the preceding claims, wherein the first and/or second characteristic alignment features (9, 9') are each arranged on the lateral edge of the first and second substrate (7, 7').

6. The method according to at least one of the preceding claims, wherein one or more of the features listed below are used as first and/or second characteristic alignment features (9, 9'):
• circular substrate edge section and/or
• flat substrate edge section and/or
• notch-shaped substrate edge section and/or
• points of intersection of the aforementioned features and/or
• points of intersection of tangents of the aforementioned features.

7. A device for the alignment of a first substrate (7) comprising at least two first alignment marks (8) with a second substrate (7') comprising at least two second alignment marks (8'), with
- a first assignment module (3) for the assignment of the first assignment marks (8) to at least two first characteristic assignment features (9) of the first substrate (7) in an X-direction and in a Y-direction, wherein first X- and Y-positions (X1, Y1, X2, Y2) are determined by measuring the first alignment marks (8) in relation to the first characteristic alignment features (9),
- a second assignment module (3') for the assignment of the second assignment marks (8') to at least two second characteristic assignment features (9') of the second substrate (7') in an X-direction and
in a Y-direction, wherein second X- and Y-positions (X1', Y1', X2', Y2') are determined by measuring the second alignment marks (8') in relation to the second characteristic alignment features (9'),
- an alignment module, constituted in particular as a bonding module, for the alignment of the first (8) and second alignment marks (8') in relation to one another in the X- and Y-direction by means of the first and second characteristic alignment features (9, 9'), wherein the alignment of the substrates (7, 7') takes place with the aid of the first X- and Y-positions (X1, Y1, X2, Y2) and the second X- and Y-positions (X1', Y1', X2', Y2'), in such a way that the alignment marks (8, 8') are arranged congruent, wherein a transfer of the substrates (7, 7') into a bonding module takes place after the first and second assignment and before the alignment.

8. The device according to claim 7, wherein the assignment modules are constituted as locks to the alignment module.

9. The device according to claim 7 or 8, with
- first detection means, in particular each arranged in the assignment modules (3, 3'), for detecting X-coordinates and Y-coordinates of the first and second alignment marks (8, 8'),
- second detection means, in particular each arranged in the assignment modules (3, 3'), for detecting X-coordinates and Y-coordinates of the first and second characteristic alignment features (9, 9'),
- third detection means (15), in particular arranged in the alignment module, for detecting X'-coordinates and Y'-coordinates of the first and second characteristic alignment features (9, 9').

## Revendications

1. Procédé pour aligner un premier substrat (7) présentant au moins deux premiers marquages d'alignement (8) avec un second substrat (7') présentant au moins deux seconds marquages d'alignement (8'), dans lequel
- par un premier agencement, les premiers marquages d'alignement (8) sont attribués à au moins deux premières caractéristiques d'alignement (9) du premier substrat (7) dans un sens X et dans un sens Y, dans lequel en mesurant les premiers marquages d'alignement (8) par rapport aux premières caractéristiques d'alignement (9), des premières positions X et Y (X1, Y1, X2, Y2) sont déterminées,
- par un second agencement, les seconds marquages d'alignement (8') sont attribués à au moins deux secondes caractéristiques d'alignement (9') du second substrat (7') dans un sens X et dans un sens Y, dans lequel en mesurant les seconds marquages d'alignement (8') par rapport aux secondes caractéristiques d'alignement (9'), des secondes positions X et Y (X1', Y1', X2', Y2') sont déterminées,
- dans lequel par un alignement, les premier (8) et seconds (8') marquages d'alignement sont alignés entre eux dans un sens X et Y au moyen des premières et secondes caractéristiques d'alignement (9, 9'), dans lequel à l'aide des premières positions X et Y (X1, Y1, X2, Y2) et des secondes positions X et Y (X1', Y1', X2', Y2'), l'alignement des substrats (7, 7') a lieu de telle sorte que les marquages d'alignement (8, 8') sont agencés en se superposant, dans lequel après la première et la seconde attribution et avant l'alignement, un transfert des substrats (7, 7') est effectué dans un module de collage.

2. Procédé selon la revendication 1, **caractérisé en ce que** dans le module de collage, l'alignement est effectué de préférence sous une pression gazeuse inférieure à 1 bar.

3. Procédé selon la revendication 1 ou 2, dans lequel la première attribution a lieu dans un premier module d'attribution (3), conçu en particulier en tant que sas, et la deuxième attribution a lieu dans un deuxième module d'attribution (3') conçu en particulier en tant que sas, en particulier parallèle à la première attribution.

4. Procédé selon au moins l'une des revendications 2 ou 3, dans lequel avant l'alignement, en particulier dans le premier et/ou le second module d'attribution, de préférence pendant l'attribution, la pression gazeuse est réduite, de préférence à une pression gazeuse inférieure à 1 bar, plus encore de préférence inférieure à 10⁻³ bar, plus encore de préférence inférieure à 10⁻⁵ bar, de manière la plus préférée inférieure à 10⁻⁸ bar.

5. Procédé selon l'une des revendications précédentes, dans lequel les premières et/ou secondes caractéristiques d'alignement (9. 9') sont disposées respectivement sur le bord latéral des premier et second substrats (7, 7').

6. Procédé selon l'une des revendications précédentes, dans lequel une ou plusieurs des caractéristiques listées suivantes est/sont employée(s) en tant que première et/ou seconde caractéristique d'alignement (9, 9') :
• tronçon de bord circulaire de substrat et/ou
• tronçon de bord plat de substrat et/ou
• tronçon de bord de substrat formé comme une encoche et/ou
• point d'intersection de la caractéristique précédente et/ou point d'intersection de tangentes de la caractéristique précédente.

7. Dispositif pour aligner un premier substrat (7) présentant au moins deux premiers marquages d'alignement (8) avec un second substrat (7') présentant au moins deux seconds marquages d'alignement (8'), comprenant
- un premier module d'attribution (3) pour attribuer les premiers marquages d'alignement (8) à au moins deux premières caractéristiques d'alignement (9) du premier substrat (7) dans un sens X et dans un sens Y, dans lequel en mesurant les premiers marquages d'alignement (8) par rapport aux premières caractéristiques d'alignement (9), des premières positions X et Y (X1, Y1, X2, Y2) sont déterminées,
- un second module d'attribution (3') pour attribuer les seconds marquages d'alignement (8') à au moins deux secondes caractéristiques d'alignement (9') du second substrat (7') dans un sens X et dans un
sens Y, dans lequel en mesurant les seconds marquages d'alignement (8') par rapport aux secondes caractéristiques d'alignement (9'), des secondes positions X et Y (X1', Y1', X2', Y2') sont déterminées,
- un module d'alignement conçu en particulier en tant que module de collage, pour aligner les premier (8) et seconds (8') marquages d'alignement au moyen des premières et secondes caractéristiques d'alignement (9, 9') entre eux dans un sens X et Y, dans lequel à l'aide des premières positions X et Y (X1, Y1, X2, Y2) et des secondes positions X et Y (X1', Y1', X2', Y2'), l'alignement des substrats (7, 7') a lieu de telle sorte que les marquages d'alignement (8, 8') sont agencés en se superposant, dans lequel après la première et la seconde attribution et avant l'alignement, un transfert des substrats (7, 7') est effectué dans un module de collage.

8. Dispositif selon la revendication 7, dans lequel les modules d'attribution sont conçus en tant que sas vers le module d'alignement.

9. Dispositif selon la revendication 7 ou 8, comprenant
- des premiers moyens de détection, en particulier disposés respectivement dans les modules d'attribution (3, 3') pour détecter des coordonnées X et des coordonnées Y des premiers et seconds marquages d'alignement (8, 8'),
- des deuxièmes moyens de détection, en particulier disposés respectivement dans les modules d'attribution (3, 3') pour détecter des coordonnées X et des coordonnées Y des premières et secondes caractéristiques d'alignement (9, 9'),
- des troisièmes moyens de détection (15), en particulier disposés dans le module d'alignement pour détecter des coordonnées X'
et des coordonnées Y' des premières et secondes caractéristiques d'alignement (9, 9').
